# EUROPEAN PATENT APPLICATION

(11) **EP 0 575 126 A1**
(43) Date of publication of application: **22.12.1993**
(21) Application number: 93304590.8
(22) Date of filing: 14.06.1993
(51) Int. Cl.: H01J 37/32

(54) **Plasma reactor head and electrode assembly**

(30) Priority: 17.06.1992 US 899800
(71) Applicant: Hughes Aircraft Company, Los Angeles, California 90080-0028 (US)
(72) Inventor: Hansell, Eric, Redding, CT 06896 (US)
(74) Representative: Colgan, Stephen James

(57) **Abstract**

A plasma reactor head assembly **10** is constructed so as to receive removable and replaceable electrodes. The electrode **12** used with the assembly **10** has interior cooling passages **38** providing increased cooling capacity to the electrode.

## Description

### Field of the Invention

The present invention relates to a plasma reactor head assembly for a plasma assisted chemical etching reactor, and more particularly, to a plasma reactor head assembly designed to utilize a removable electrode having improved cooling surface area therein for use in a multi-axis plasma assisted chemical etching system.

### Background of the Invention

Prior art plasma assisted chemical etching reactor heads are not interchangeable, are relatively heavy and utilize a V-groove for cooling. The plasma reactor head assembly of the present invention presents an improvement over prior art reactor heads in that it provides an interchangeable head which is relatively light so as to allow multiple axes mounting and uses a removable electrode having larger cooling surface area therein for use with higher rf power.

### SUMMARY OF THE INVENTION

The present invention relates to a removable plasma reactor head electrode having an increased cooling surface area therein and a plasma reactor head assembly designed to accept the removable electrode. The increased cooling surface area is accomplished by lengthening the cooling passages within the electrode so as to more evenly distribute coolant within the electrode. The electrode is housed within a conically shaped main body of the plasma reactor head assembly. An insulative spacer and insulative upper core member are provided to secure the electrode within the main body. The electrode may be replaced with a larger or smaller electrode secured by corresponding insulative spacers and insulative upper core member.

Another object of the present invention is to provide a lightweight reactor head assembly.

One object of the present invention is to provide a plasma assisted chemical etching electrode with increased cooling capacity.

Another object of the present invention is to provide a plasma assisted chemical etching electrode with higher rf power handling capability.

Another object of the present invention is to provide a removable reactor head for a plasma assisted chemical etching reactor system.

Another object of the present invention is to provide a removable reactor head receptive to a plurality of different sized removable electrodes.

Another object of the present invention is to provide a lightweight reactor head assembly.

Other objects and advantages of the present invention will become apparent to those skilled in the art from the specification, claims and drawings appended hereto.

### DETAILED DESCRIPTION OF THE DRAWINGS

Figure 1 is a schematic diagram showing a cross section of the reactor head assembly of the present invention along the plane of line 1-1 of Figure 2.

Figure 2 is a schematic diagram showing a top view of the reactor head assembly of the present invention taken along the plane of 2-2 in Figure 1.

Figure 3 is top view of the electrode of the present invention.

Figure 4 is a cross section view of the electrode taken along the plane of line 4-4 in Figure 3.

Figure 5 is a cross section view of the electrode taken along the plane of line 5-5 in Figure 3.

Figure 6 is a cross section of a prior art electrode with a V-groove cooling passage taken along a plane equivalent to line 5-5 in Figure 3.

### DETAILED DESCRIPTION OF THE PRESENT INVENTION

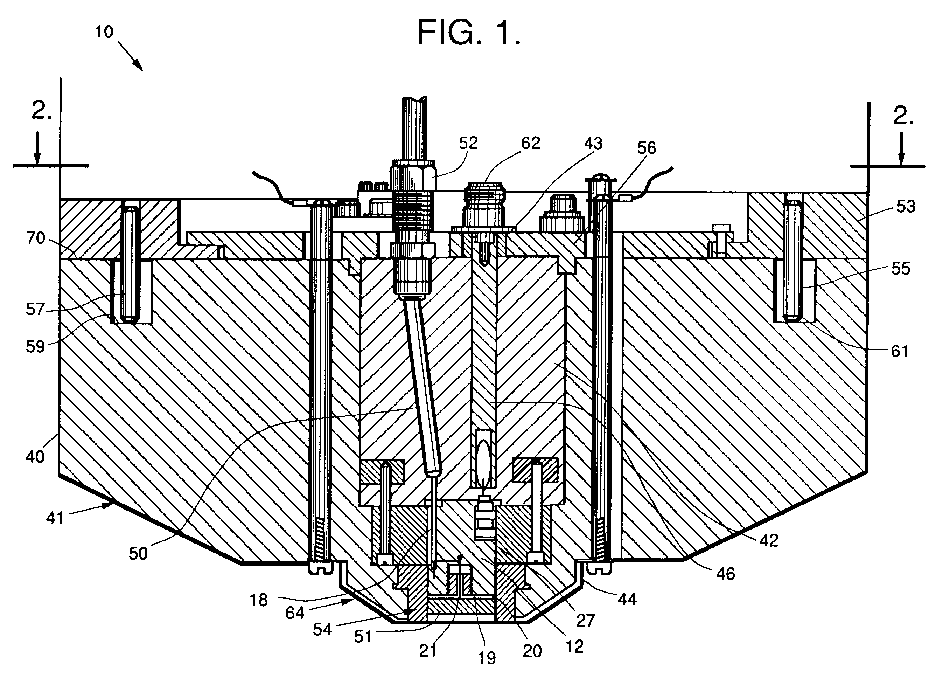

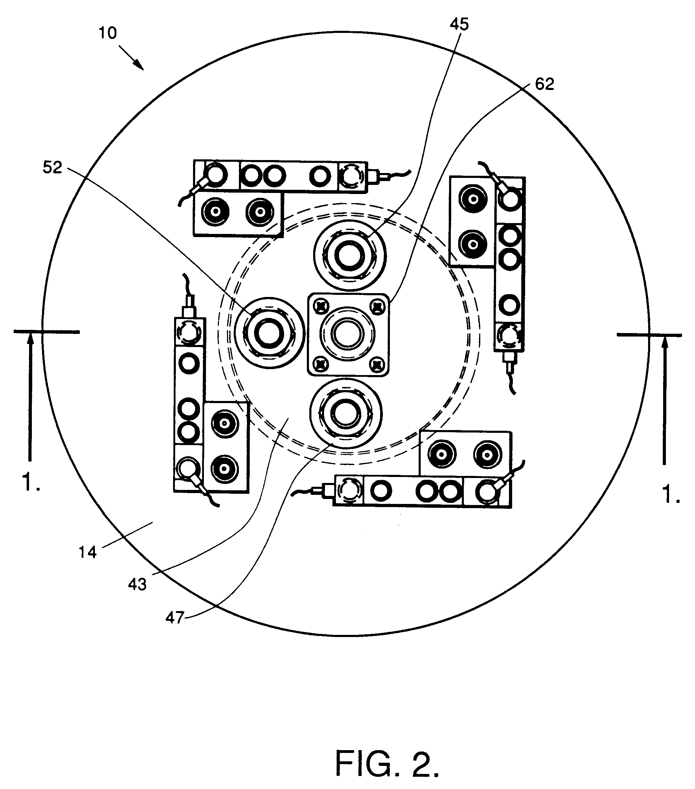

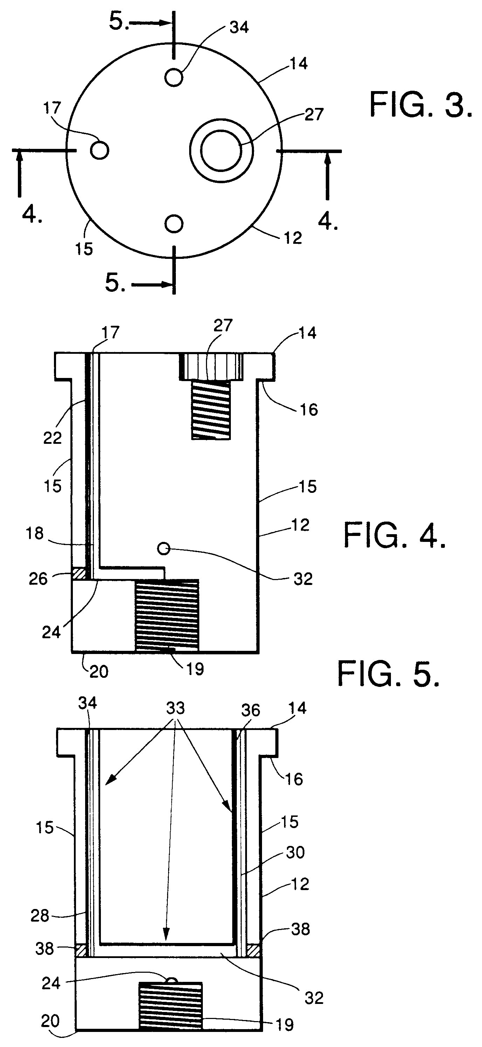

Figure 1 shows a cross sectional view of the reactor head assembly **10** of the present invention taking along the line 1-1 of Figure 2. Figure 2 shows a top view of the reactor head assembly of the present invention taken along the line 2-2 of Figure 1. Figures 3, 4 and 5 show a top and two cross sectional views of the cylindrical electrode **12** used in the reactor head assembly of the present invention. Referring to Figure 4, the cylindrical electrode **12** has an upper surface **14** which extends past vertical walls **15** so as to form a flange load bearing surface **16**. A process gas passage **18** extends from the upper surface **14** at inlet **17** to a central threaded cavity **19** projecting inwardly toward the upper surface **14** from a bottom surface **20**. A rf conductive gas diffuser (not shown) is threaded into cavity **19**. The passage **18** is formed from the joining of a first vertical subpassage **22** to a first horizontal subpassage **24**. The horizontal subpassage is obtained by drilling radially into the electrode to a depth which makes contact with the centrally threaded cavity **19**. The vertical passage is obtained by drilling into the top surface **14** of the electrode to a depth so as to connect with the horizontal passage. A plug **26** is welded in place over a hole extending from the horizontal subpassage **24** so as to provide a continuous process gas flow passage starting from the inlet **17**, through the first vertical subpassage **22**, to the horizontal subpassage **24** and finally to the cavity **19**. A top threaded cavity **27** extends inwardly from the top surface **14** to provide a receptacle for rf power to the electrode.

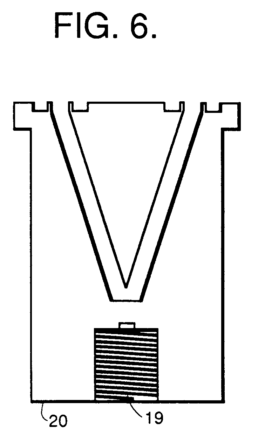

Referring to Figure 5, the electrode **12** has second and third vertical subpassages **28** and **30** joined to a second horizontal subpassage **32** so as to form a cooling passage **33** in the electrode having an inlet **34** and an outlet **36** extending through the top surface **14**. The second horizontal subpassage is formed by drilling through the walls **15** of the electrode **12** above the first horizontal subpassage **24** and the cooling passage is made continuous by plugs **38** welded into place at the walls **15** where the horizontal subpassage extends therethrough. The cooling passage allows greater dissipation of heat, and thus higher rf power (up to 250 watts), than a prior art V-groove type cooling channel as shown in Figure 6 due to the increased cooling surface area within the electrode **12**.

Referring to Figures 1 and 2 showing the reactor head assembly, the electrode **12** is contained within the interior of an annular main insulative body **40** having a conically shaped nose **41**. The conical shape of the nose permits the reactor head assembly of the present invention to be used more easily in multiple axes configurations than a square head design because the conical shape allows a greater degree of freedom for head placement when the electrode is in close proximity to a substrate located below. A 30° rise from the bore at the bottom of the main body to the bottom of the main body at the sides has been found sufficient for adequate head placement. The construction of the reactor head assembly is begun by attaching electrode **12** to an upper insulative core member **42**, machined from Mecor™, a machinable ceramic manufactured by Owens-Corning, by an insulative retaining ring **44**, machined from poly-tetra-fluro-ethylene (PTFE), which bears on the flange surface **16**. A rf power conductor **46** contained within the upper core member **42** which also extends through upper surface **43** is connected to the threaded cavity **27** of the electrode **12**. The upper core member also contains a large process gas passage **50** which also extends through upper surface **43** and is connected to the process gas inlet **17** of the electrode **12**. Supply and return cooling lines (not shown) also within the upper core member are connected to the cooling inlet **34** and cooling outlet **36** and extend through upper surface **43** to inlet **45** and outlet **47**. After the electrode **12** and the upper core member **42** have been joined, a fused silica insulative spacer **54** is inserted into the bore of the main body and is supported by a portion of the main body having a reduced interior diameter. The spacer is dimensioned so as to have an outside diameter which remains constant and an inside diameter approximately equal to the diameter of the electrode in use. Next, the electrode **12** and upper core member are inserted into the main body so that retaining ring **44** rests on a portion of the interior of the main insulative body **40** and an upper surface of the fused silica insulative spacer **54**. The use of the spacer eliminates the need for exchanging the entire main body **40** each time a different diameter electrode **12** is used. The spacer walls that define the spacer bore also define plasma chamber **51**.

After the electrode and upper core is inserted into the main body, the main body **40** is positioned proximal to a cradle **53**. The cradle has a plurality of guide pins **55** and **57** for alignment with a plurality of bores **59** and **61** in the upper surface **70** of the main body. After the upper surface of the main body is positioned adjacent to the cradle, an insulative plug **43** machined from PTFE is placed around the portion of the rf conductor which extends beyond the upper surface of the upper core **42**. A supply of process gas is connected to the process gas passage **50** by an SAE/MS connector **52**. Next, a 6061-T6 aluminum core head cap **56** is placed over the main body **40** and upper core **42** and the main body is secured to the cradle by several bolts. The rf conductor is then connected to a rf power source by a rf connector assembly **62**. Cooling supply and return lines are connected to cooling inlet **45** and cooling outlet **47**. A 3003-0 aluminum alloy protective bumper **64** may be placed over the exterior lower portion of the main body so as to protect the main body from accidental collisions with substrates.

Thus, what has been described is a plasma reactor head assembly which is lightweight, readily interchangeable, having an electrode which has greater cooling channel surface area for use with rf power up to 250 watts.

## Claims

1. An electrode for a plasma reactor head assembly comprising:
a solid electrically conductive body having a top surface and a bottom surface, wherein said bottom surface has a threaded cavity extending therein, wherein said top surface has a process gas inlet, an rf power inlet, a cooling inlet, and a cooling outlet, wherein an interior portion of said body has a process gas passage extending from said process gas inlet to said threaded cavity extending from said bottom surface, and wherein an interior portion of said body has a horizontal cooling passage at a position having a first end and a second end, a first vertical passage extending from said cooling inlet to the horizontal cooling passage at a position adjacent to the first end and a second vertical passage extending from said cooling outlet to the horizontal cooling passage at a position adjacent to the second end.

2. The electrode of Claim 1, wherein the body is cylindrical.

3. A method for constructing an electrode for a plasma reactor head from a solid electrically conductive body having a top surface, a bottom surface and sides, said method comprising:
boring a cavity in the bottom surface for receiving a gas diffuser;
drilling a first horizontal passage from a side of said body to the cavity so as to connect said passage to the cavity;
drilling a first vertical passage from said top surface to said first horizontal passage so as to connect said first vertical passage with said first horizontal passage;
plugging a hole in the side of said body created by the drilling of said first horizontal passage so as to form a continuous passage from said first vertical passage and said first horizontal passage.
drilling a second horizontal passage having a first end and a second end from a first side and through a second and opposite side;
drilling a second vertical passage from said top surface to a depth so as to connect said second horizontal passage at a position adjacent to said first end to said second vertical passage;
drilling a third vertical passage from said top surface to a depth so as to connect said second horizontal passage at a position adjacent to said second and opposite end to said third vertical passage;
plugging holes in the sides of said body created by the drilling of said second horizontal passage so as to form a continuous passage from said second vertical passage through said second horizontal passage and to said third vertical passage; and
boring a cavity in said top surface of said body for receiving an rf power supply.

4. A plasma reactor head assembly, comprising:
an insulative main body having a top, a bottom, sides and a bore extending from said top to said bottom;
an insulative spacer having a top, a bottom, sides and a bore extending from said top to said bottom, wherein said spacer is positioned at the bottom of the bore of said main body;
an electrode within the bore of said main body having a portion thereof within the bore of said spacer, wherein said electrode comprises: a solid electrically conductive body having a top surface and a bottom surface, wherein said bottom surface has a threaded cavity extending therein, wherein said top surface has a process gas inlet, an rf power inlet, a cooling supply inlet, and a cooling return outlet, wherein an interior portion of said body has a process gas passage extending from said process gas inlet to said threaded cavity exteading from said bottom surface, and wherein an interior portion of said body has a horizontal cooling passage having a first end and second end, a first vertical passage extending from said cooling inlet to a position adjacent to the first end of said horizontal cooling passage and a second vertical passage extending from said cooling outlet to a position adjacent to the second end of said horizontal cooling passage so as to form a continuous cooling passage;
an upper insulative solid core having a top, a bottom, sides, a process gas passage extending from said top to said bottom, an rf conductor extending from said top to said bottom, and a supply cooling passage and a return cooling passage extending from said top to said bottom, wherein the core is positioned within the bore of the main body and wherein the bottom of said core is positioned and fixedly attached to the top surface of said electrode so as to connect the process gas passage, rf conductor, cooling supply passage and cooling return passage to the process gas inlet, rf power inlet, cooling supply inlet and cooling return outlet of said electrode.

5. The plasma reactor head of Claim 5, wherein the bottom of the main body is conically shaped, and wherein the distance from the top to the bottom along the bore of the main body is greater than the distance from the top to the bottom along the walls.

6. The plasma reactor head of Claim 5, wherein an angle measured from the bottom of the main body along the bore to the bottom of the main body at the walls is approximately 30°.

7. The plasma reactor head of Claim 4, wherein the top of the main body has a plurality of bores receptive to guide pins for positioning said body.

8. The plasma reactor head of Claim 4, wherein the top of the main body has a plurality of bores receptive to guide pins for positioning the body.

9. The plasma reactor head of Claim 4, wherein the insulative main body is constructed from a machinable ceramic.

10. An insulative member for surrounding a plasma assisted chemical etching reactor electrode, comprising a top, a bottom, sides, and a bore extending from the top to the bottom, wherein the bottom is conically shaped, and wherein the distance from the top to the bottom along the bore is greater than the distance from the top to the bottom along the sides.
